(19) Europäisches Patentamt
European Patent Office
Office européen des brevets

(11) **EP 4 664 757 A1**

(12) **EUROPEAN PATENT APPLICATION**
published in accordance with Art. 153(4) EPC

(43) Date of publication:
**17.12.2025 Bulletin 2025/51**

(21) Application number: **24753458.9**

(22) Date of filing: **09.02.2024**

(51) International Patent Classification (IPC):
**H03F 1/30** (2006.01)   **H03F 1/22** (2006.01)
**H03F 3/21** (2006.01)   **H03F 3/45** (2006.01)

(52) Cooperative Patent Classification (CPC):
**H03F 1/22; H03F 1/30; H03F 3/21; H03F 3/45**

(86) International application number:
**PCT/JP2024/004655**

(87) International publication number:
**WO 2024/167015 (15.08.2024 Gazette 2024/33)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.02.2023 JP 2023019122**

(71) Applicant: **Fujikura Ltd.
Tokyo 135-8512 (JP)**

(72) Inventor: **KAMIDAKI Chihiro
Sakura-shi, Chiba 285-8550 (JP)**

(74) Representative: **Lavoix
Bayerstraße 83
80335 München (DE)**

(54) **POWER AMPLIFIER**

(57)    The present invention provides a power amplifier including a main circuit that includes an initial-stage transistor and a next-stage transistor, which are connected in cascode, and is configured to amplify an input signal to output a high-frequency amplified signal, and a bias circuit that is configured to apply a bias voltage to the next-stage transistor, in which the bias circuit is a constant voltage circuit that generates the bias voltage having a constant voltage based on a power supply supplied, from an outside, to a power supply terminal.

FIG. 1

# Description

## TECHNICAL FIELD

The present invention relates to a power amplifier.

Priority is claimed on Japanese Patent Application No. 2023-019122, filed February 10, 2023, the content of which is incorporated herein by reference.

## BACKGROUND ART

A high-frequency power amplifier capable of suppressing power consumption with higher efficiency than in the related art is disclosed in Patent Document 1. The high-frequency power amplifier is configured of an input terminal, an output terminal, an input matching circuit, an output matching circuit, a first power supply terminal, a second power supply terminal, a base bias terminal, a base bias resistor, a cascode amplifier in which a first transistor for high-frequency amplification and a second transistor for high-frequency amplification are stacked in two stages, a load inductor connected between a collector of a second transistor and the first power supply terminal, a first voltage-dividing resistor connected between a base of the second transistor for high-frequency amplification and the second power supply terminal, a second voltage-dividing resistor connected between the base of the second transistor for high-frequency amplification and a ground terminal, and a capacitor for high-frequency ground connected between the base of the second transistor for high-frequency amplification and the ground terminal.

In the high-frequency power amplifier, a radio frequency signal is input to the input terminal, appropriate voltages are each applied to the base bias terminal, the first power supply terminal, and the second power supply terminal, and the input matching circuit and the output matching circuit are each appropriately matched with a base of the first transistor and the collector of the second transistor at a frequency of the radio frequency signal. With the above, an amplified signal can be extracted from the output terminal. Further, in the high-frequency power amplifier, with adjustment of a ratio of a value of the first voltage-dividing resistor to a value of the second voltage-dividing resistor, it is easy to control a base voltage (cascode base bias voltage) of the second transistor for high-frequency amplification, and the second transistor for high-frequency amplification can be appropriately biased.

## Citation List

## Patent Document

Patent Document 1: Japanese Unexamined Patent Application, First Publication No. 2012-147307

## SUMMARY OF INVENTION

## Technical Problem

In a circuit configuration in which a plurality of power supply terminals are used, in a case where the power supply terminals are each to be connected to different external power supplies, a user of the circuit needs to prepare a plurality of external power supplies, which is inefficient. As a method of eliminating the inefficiency, it is conceivable to delete the second power supply terminal, connect the first and second voltage-dividing resistors to the base of the second transistor for high-frequency amplification therebetween, and adjust the base voltage (cascode base bias voltage) of the second transistor for high-frequency amplification, that is, the ratio of the values of the voltage-dividing resistors.

However, in a case where such an elimination method is employed, the following problems may occur. That is, in a case where there is a parasitic resistance between the first power supply terminal and a voltage source applying a voltage to the first power supply terminal (for example, a wiring resistance of a wiring line disposed between the voltage source and the first power supply terminal) due to some cause, collector currents of the first transistor for high-frequency amplification and the second transistor for high-frequency amplification increase as magnitude of the radio frequency signal increases. As a result, the base voltage and a collector voltage of the second transistor are decreased.

As a result, a collector voltage of the first transistor for high-frequency amplification decreases in response to a decrease in the cascode base bias voltage, and a current amplification factor of the first transistor for high-frequency amplification decreases due to the Early effect. As a result, output power decreases. In a case where separate external power supplies are each connected to the first power supply terminal and the second power supply terminal, even though there is a resistor between the first power supply terminal and the external power supply applying a voltage to the first power supply terminal or between the second power supply terminal and the external power supply applying a voltage to the second power supply terminal, the base voltage (cascode base bias voltage) of the second transistor does not decrease. Thus, the collector voltage of the first transistor for high-frequency amplification is held, and the output power is not relatively decreased.

The present invention has been made in view of the above circumstances, and an object of the present invention is to provide a power amplifier capable of suppressing a reduction in output power due to a voltage drop in a bias voltage.

## Solution to problem

A first aspect of the present invention is a power amplifier including a main circuit that includes an initial-stage transistor and a next-stage transistor, which are connected in cascode, and is configured to amplify an input signal to output a high-frequency amplified signal, and a bias circuit that is configured to apply a bias voltage to the next-stage transistor, in which the bias circuit is a constant voltage circuit that generates the bias voltage having a constant voltage based on a power supply supplied, from an outside, to a power supply terminal.

A second aspect of the present invention is the power amplifier according to the first aspect, in which the bias circuit is configured to generate a reference constant voltage by a base-emitter voltage of one bipolar transistor or a base-emitter voltage of a plurality of bipolar transistors connected in series.

A third aspect of the present invention is the power amplifier according to the second aspect, in which the number of the bipolar transistors is two.

A fourth aspect of the present invention is the power amplifier according to any one of the first to third aspects, in which the main circuit is a differential amplification circuit that includes a pair of the initial-stage transistors and a pair of the next-stage transistors and that is configured to amplify a pair of input signals to output a pair of amplified signals.

A fifth aspect of the present invention is the power amplifier according to the fourth aspect, further including a pair of bias terminals that are configured to individually set amplification degrees of the initial-stage transistors.

A sixth aspect of the present invention is the power amplifier according to any one of the first to fifth aspects, in which the bias circuit includes a first NPN type bipolar transistor for bias having an emitter terminal that is connected to a ground line, and a base terminal and a collector terminal that are commonly connected, a second NPN type bipolar transistor for bias having an emitter terminal that is connected to the base terminal and the collector terminal of the first NPN type bipolar transistor for bias, a third NPN type bipolar transistor for bias having a base terminal that is connected to a collector terminal of the second NPN type bipolar transistor for bias, a first resistor for bias having one end that is connected to the base terminal and the collector terminal of the first NPN type bipolar transistor for bias, and the other end that is connected to a power supply line, a second resistor for bias having one end that is connected to the power supply line, and the other end that is connected to the collector terminal of the second NPN type bipolar transistor for bias and the base terminal of the third NPN type bipolar transistor for bias, a third resistor for bias having one end that is connected to a base terminal of the second NPN type bipolar transistor for bias, and the other end that is connected to an emitter terminal of the third NPN type bipolar transistor for bias, a fourth resistor for bias having one end that is connected to the ground line, and the other end that is connected to the base terminal of the second NPN type bipolar transistor for bias and the one end of the third resistor for bias, and a capacitor having

one end that is connected to the ground line, and the other end that is connected to the emitter terminal of the third NPN type bipolar transistor for bias and the other end of the third resistor for bias, and the bias circuit outputs the bias voltage from the emitter terminal of the third NPN type bipolar transistor for bias.

A seventh aspect of the present invention is the power amplifier according to any one of the first to third and sixth aspects, in which the main circuit includes an input matching circuit having an input end that is connected to a high-frequency input terminal, an initial-stage NPN type bipolar transistor having a base terminal that is connected to an output end of the input matching circuit, and an emitter terminal that is connected to a ground terminal, a resistor for amplification having one end that is connected to the output end of the input matching circuit and a base terminal of the initial-stage transistor, and the other end that is connected to a bias terminal, a next-stage NPN type bipolar transistor having an emitter terminal that is connected to a collector terminal of the initial-stage NPN type bipolar transistor, and a base terminal that receives the bias voltage, an inductor having one end that is connected to a collector terminal of the next-stage NPN type bipolar transistor, and the other end that is connected to a power supply terminal, and an output matching circuit having an input end that is connected to the collector terminal of the next-stage NPN type bipolar transistor and one end of the inductor, and an output end that is connected to a high-frequency output terminal.

An eighth aspect of the present invention is the power amplifier according to any one of the first to sixth aspects, in which the main circuit includes an input matching circuit having one input end that is connected to a first high-frequency input terminal, and the other input end that is connected to a second high-frequency input terminal, a first initial-stage NPN type bipolar transistor having a base terminal that is connected to the one output end of the input matching circuit, and an emitter terminal that is connected to a ground terminal, a second initial-stage NPN type bipolar transistor having a base terminal that is connected to the other output end of the input matching circuit, and an emitter terminal that is connected to the ground terminal, a first resistor for amplification having one end that is connected to the one output end of the input matching circuit and the base terminal of the first initial-stage NPN type bipolar transistor, and the other end that is connected to a first bias terminal, a second resistor for amplification having one end that is connected to the other output end of the input matching circuit and the base terminal of the second initial-stage NPN type bipolar transistor, and the other end that is connected to a second bias terminal, a first next-stage NPN type bipolar transistor having an emitter terminal that is connected to a collector terminal of the first initial-stage NPN type bipolar transistor, and a base terminal that receives the bias voltage, a second next-stage NPN type bipolar transistor having an emitter terminal that is connected to a collector terminal of the second initial-stage NPN type bipolar transistor, and a base terminal that receives the bias voltage, a first inductor having one end that is connected to a collector terminal of the first next-stage NPN type bipolar transistor, and the other end that is connected to a power supply terminal, a second inductor having one end that is connected to a collector terminal of the second next-stage NPN type bipolar transistor, and the other end that is connected to the power supply terminal, and an output matching circuit having one input end that is connected to the collector terminal of the first next-stage NPN type bipolar transistor and the one end of the first inductor, the other input end that is connected to the collector terminal of the second next-stage NPN type bipolar transistor and the one end of the second inductor, one output end that is connected to a first high-frequency output terminal, and the other output end that is connected to a second high-frequency output terminal.

A ninth aspect of the present invention is the power amplifier according to any one of the first to eighth aspects, in which an emitter length of the next-stage transistor is set to be larger than an emitter length of the initial-stage transistor.

Advantageous Effects of Invention

According to the present invention, it is possible to provide the power amplifier capable of suppressing the reduction in output power due to the voltage drop in the bias voltage.

BRIEF DESCRIPTION OF DRAWINGS

[FIG. 1] A circuit diagram showing a configuration of a high-frequency power amplifier according to a first embodiment of the present invention.
[FIG. 2A] A first characteristic diagram showing performance of the high-frequency power amplifier according to the first embodiment of the present invention.
[FIG. 2B] A first characteristic diagram showing the performance of the high-frequency power amplifier according to the first embodiment of the present invention.
[FIG. 3] A second characteristic diagram showing the performance of the high-frequency power amplifier according to the first embodiment of the present invention.
[FIG. 4] A third characteristic diagram showing the performance of the high-frequency power amplifier according to the first embodiment of the present invention.
[FIG. 5] A circuit diagram showing a configuration of a high-frequency power amplifier according to a second embodiment of the present invention.

[FIG. 6] A characteristic diagram showing performance of the high-frequency power amplifier according to the second embodiment of the present invention.

DESCRIPTION OF EMBODIMENTS

Hereinafter, embodiments of the present invention will be described with reference to drawings.

[First Embodiment]

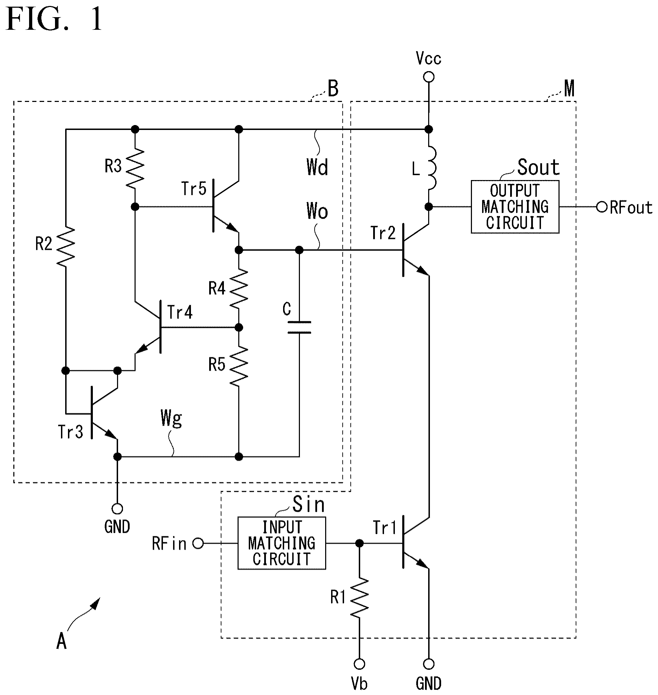

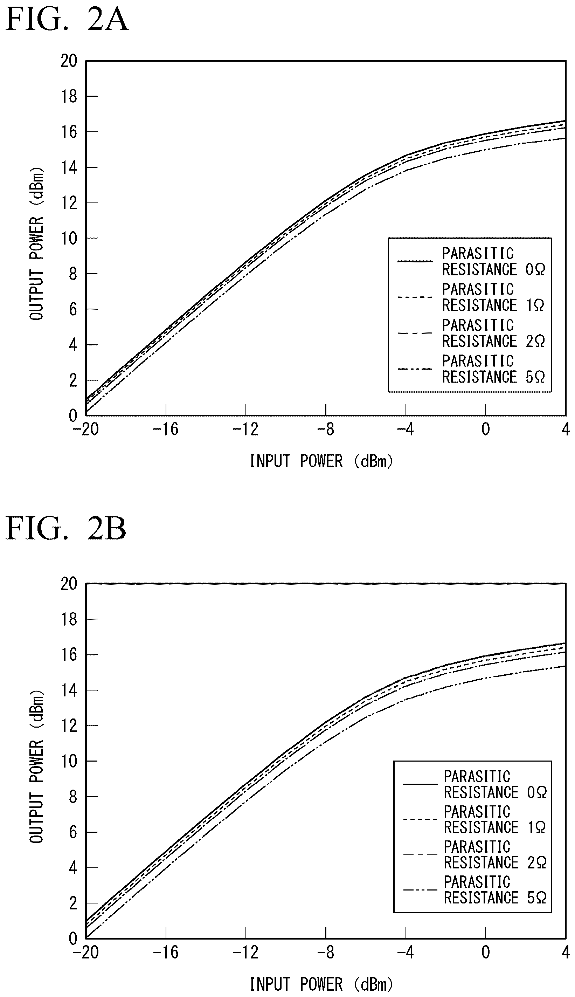

First, a first embodiment of the present invention will be described with reference to FIGS. 1, 2A, and 2B. As shown in FIG. 1, a high-frequency power amplifier A according to the first embodiment includes a high-frequency input terminal RFin, an input matching circuit Sin, a first transistor Tr1 (initial-stage NPN type bipolar transistor), a first resistor R1, a bias terminal Vb, a second transistor Tr2 (next-stage NPN type bipolar transistor), an inductor L, an output matching circuit Sout, a high-frequency output terminal RFout, a ground terminal GND, a power supply terminal Vcc, a third transistor Tr3 (first NPN type bipolar transistor for bias), a second resistor R2 (first resistor for bias), a fourth transistor Tr4 (second NPN type bipolar transistor for bias), a third resistor R3 (second resistor for bias), a fifth transistor Tr5 (third NPN type bipolar transistor for bias), a fourth resistor R4 (third resistor for bias), a fifth resistor R5 (fourth resistor for bias), and a capacitor C.

Among the above components, the input matching circuit Sin, the first transistor Tr1, the second transistor Tr2, the first resistor R1, the inductor L, and the output matching circuit Sout configure a main circuit M. Further, the third transistor Tr3, the fourth transistor Tr4, the fifth transistor Tr5, the second resistor R2, the third resistor R3, the fourth resistor R4, the fifth resistor R5, and the capacitor C configure a bias circuit B as shown in the drawing.

The high-frequency input terminal RFin is an input end of the high-frequency power amplifier A (main circuit M) and is connected to an input end of the input matching circuit Sin. A high-frequency signal having a predetermined frequency is input to the high-frequency input terminal RFin from an outside. The high-frequency signal is an input signal in the high-frequency power amplifier A, and is input to the input end of the input matching circuit Sin.

The input end of the input matching circuit Sin is connected to the high-frequency input terminal RFin, and an output end thereof is connected to a base terminal of the first transistor Tr1 and one end of the first resistor R1. The input matching circuit Sin is a passive circuit for impedance matching of the high-frequency signal (input signal), and suppresses reflection of the high-frequency signal (input signal) to cause more power to be input to the base terminal of the first transistor Tr1.

The first transistor Tr1 is an NPN type bipolar transistor as shown in the drawing, and the base terminal of the first transistor Tr1 is connected to the output end of the input matching circuit Sin and the one end of the first resistor R1. Further, an emitter terminal of the first transistor Tr1 is connected to a ground terminal GND, and a collector terminal thereof is connected to an emitter terminal of the second transistor Tr2. Such a first transistor Tr1 is connected in cascode with the second transistor Tr2, and corresponds to an initial-stage transistor of the present invention.

The first resistor R1 has a predetermined first resistance value, and the one end of the first resistor R1 is connected to the output end of the input matching circuit Sin and the base terminal of the first transistor Tr1, and the other end thereof is connected to the bias terminal Vb. The first resistor R1 is provided between the bias terminal Vb and the base terminal of the first transistor Tr1, in order to set a base voltage (bias voltage) of the first transistor Tr1.

The bias terminal Vb is a terminal to which a predetermined bias voltage is supplied from an external bias power supply. The bias terminal Vb is connected to the other end of the first resistor R1. The base voltage (bias voltage) of the first transistor Tr1 is a parameter for setting an amplification degree of the first transistor Tr1. The bias terminal Vb is provided to enable the setting of the amplification degree of the first transistor Tr1 from the outside.

The second transistor Tr2 is an NPN type bipolar transistor, similar to the first transistor Tr1, and a base terminal of the second transistor Tr2 is connected to an output end Wo of the bias circuit B. Further, the emitter terminal of the second transistor Tr2 is connected to the collector terminal of the first transistor Tr1, and a collector terminal thereof is connected to one end of the inductor L and an input end of the output matching circuit Sout.

Such a second transistor Tr2 is connected in cascode with the first transistor Tr1, and corresponds to a next-stage transistor of the present invention. With an applied base bias voltage (output voltage Vc) having a constant voltage from the output end Wo of the bias circuit B, the second transistor Tr2 functions as an amplification element together with the first transistor Tr1. That is, an amplified signal (high-frequency signal), which is an amplified high-frequency signal (input signal) in the main circuit M, is generated at the collector terminal of the second transistor Tr2.

The inductor L has a predetermined inductance, and the one end of the inductor L is connected to the collector terminal of the second transistor Tr2 and the input end of the output matching circuit Sout, and the other end thereof is connected to the power supply terminal Vcc and a power supply line Wd of the bias circuit B. The inductor L is a load of the second transistor Tr2.

The input end of the output matching circuit Sout is connected to the collector terminal of the second transistor Tr2 and the one end of the inductor L, and an output end thereof is connected to the high-frequency output terminal RFout. The output matching circuit Sout is a passive circuit for impedance matching of the amplified signal (high-frequency signal), and suppresses reflection of the amplified signal (high-frequency signal) to cause more power to be input to a next-stage circuit connected externally to the high-frequency output terminal RFout.

The input matching circuit Sin and the output matching circuit Sout described above are typically configured of a combination of a capacitor, an inductor, and a transmission line. Further, the input matching circuit Sin and the output matching circuit Sout are more typically L-shaped, reverse L-shaped, T-shaped, or π-shaped network circuits configured of a capacitor, an inductor, and a transmission line. The input matching circuit Sin and the output matching circuit Sout may include a capacitor connected in series in order to block a direct current to the high-frequency input terminal RFin or the high-frequency output terminal RFout.

The high-frequency output terminal RFout is an output end of the high-frequency power amplifier A (main circuit M), and is connected to the output end of the output matching circuit Sout. The high-frequency output terminal RFout outputs a high-frequency amplified signal (output signal), which is an amplified input signal (high-frequency signal) by the high-frequency power amplifier A (main circuit M), to the next-stage circuit.

The ground terminal GND is connected to the emitter terminal of the first transistor Tr1 and a ground line Wg of the bias circuit B, as shown in the drawing. The ground terminal GND is grounded outside. That is, the ground terminal GND is set to a ground potential outside.

The power supply terminal Vcc is connected to the other end of the inductor L and the power supply line Wd of the bias circuit B. The power supply terminal Vcc is connected to a direct-current voltage power supply outside. That is, the power supply terminal Vcc is set to a power supply voltage, which is a potential higher than the ground potential of the ground terminal GND, outside.

The main circuit M in the first embodiment includes the input matching circuit Sin, the first transistor Tr1, the second transistor Tr2, the first resistor R1, the inductor L, and the output matching circuit Sout. The main circuit M amplifies the input signal (high-frequency signal) input via the high-frequency input terminal RFin in cooperation with the bias circuit B, and outputs the high-frequency amplified signal (output signal) to the next-stage circuit via the high-frequency output terminal RFout.

Further, for the first transistor Tr1 (initial-stage transistor) and the second transistor Tr2 (next-stage transistor) in the main circuit M, an emitter length of the second transistor Tr2 (next-stage transistor) is set to be equal to an emitter length of the first transistor Tr1 (initial-stage transistor), or set to be larger than the emitter length thereof. With the setting of the emitter length of the second transistor Tr2 (next-stage transistor) to be larger than the emitter length of the first transistor Tr1 (initial-stage transistor), it is possible to reduce a phase distortion of the main circuit M.

In a case where the bias circuit B in the first embodiment is described, the third transistor Tr3 is an NPN type bipolar transistor, similar to the first transistor Tr1 and the second transistor Tr2 described above. A base terminal of the third transistor Tr3 is connected to a collector terminal of the third transistor Tr3, one end of the second resistor R2, and an emitter terminal of the fourth transistor Tr4.

Further, an emitter terminal of the third transistor Tr3 is connected to the ground line Wg of the bias circuit B, that is, the ground terminal GND, and the collector terminal thereof is connected to the base terminal of the third transistor Tr3, the one end of the second resistor R2, and the emitter terminal of the fourth transistor Tr4. A base-emitter voltage of the third transistor Tr3 is the same as an emitter-collector voltage.

That is, since the base terminal and the collector terminal of the third transistor Tr3 are in common connection (so-called diode connection), the third transistor Tr3 functions as a diode. The base terminal and the collector terminal of the third transistor Tr3 function as an anode terminal of the diode, and the emitter terminal thereof functions as a cathode terminal of the diode. The base-emitter voltage (emitter-collector voltage) of the third transistor Tr3 in an ON state (conduction state) is set (clamped) to a breakdown voltage in a PN junction of the third transistor Tr3.

The second resistor R2 has a predetermined second resistance value, and the one end of the second resistor R2 is connected to the base terminal and the collector terminal of the third transistor Tr3 and the emitter terminal of the fourth transistor Tr4, and the other end thereof is connected to the power supply line Wd of the bias circuit B, that is, one end of the third resistor R3 and a collector terminal of the fifth transistor Tr5. The second resistor R2 is a current limiting resistor that sets a conduction current (collector current) of the third transistor Tr3.

The fourth transistor Tr4 is an NPN type bipolar transistor, similar to the third transistor Tr3, and a base terminal of the fourth transistor Tr4 is connected to one end of the fourth resistor R4 and is connected to the other end of the fifth resistor R5. Further, the emitter terminal of the fourth transistor Tr4 is connected to the base terminal and the collector terminal of the third transistor Tr3 and the one end of the second resistor R2, and a collector terminal thereof is connected to the one end of the third resistor R3 and a base terminal of the fifth transistor Tr5.

That is, the fourth transistor Tr4 is connected in series with the third transistor Tr3 in diode connection. Therefore, a base voltage of the fourth transistor Tr4 in the ON state (conduction state) is a constant voltage obtained by adding a base-emitter voltage $V_{BE2}$ of the fourth transistor Tr4 in the ON state (conduction state) to a base-emitter voltage $V_{BE1}$ of the third transistor Tr3 in the ON state (conduction state).

Such a base voltage of the fourth transistor Tr4 in the ON state (conduction state) is a reference constant voltage generated by the base-emitter voltages $V_{BE1}$ and $V_{BE2}$ of two (plurality of) bipolar transistors (third transistor Tr3 and fourth transistor Tr4) connected in series.

The third resistor R3 has a predetermined third resistance value, and the one end of the third resistor R3 is connected to the power supply line Wd of the bias circuit B, that is, the other end of the second resistor R2 and the collector terminal of the fifth transistor Tr5, and the other end thereof is connected to the collector terminal of the fourth transistor Tr4 and the base terminal of the fifth transistor Tr5. The third resistor R3 is a current limiting resistor that sets the conduction current (collector current) of the fourth transistor Tr4. That is, the conduction current (collector current) of the fourth transistor Tr4 is set by the third resistance value.

The fifth transistor Tr5 is an NPN type bipolar transistor, similar to the third transistor Tr3 and the fourth transistor Tr4, and the base terminal of the fifth transistor Tr5 is connected to the one end of the third resistor R3 and the collector terminal of the fourth transistor Tr4. Further, an emitter terminal of the fifth transistor Tr5 is connected to the other end of the fourth resistor R4 and the other end of the capacitor C, and the collector terminal thereof is connected to the power supply line Wd of the bias circuit B, that is, the other end of the second resistor R2 and the one end of the third resistor R3. The emitter terminal in the fifth transistor Tr5 is an output end Wo of the bias circuit B, and outputs the output voltage Vc to the main circuit M.

The fourth resistor R4 has a predetermined fourth resistance value, and one end of the fourth resistor R4 is connected to the base terminal of the fourth transistor Tr4 and the other end of the fifth resistor R5, and the other end thereof is connected to the emitter terminal of the fifth transistor Tr5 and the other end of the capacitor C. The other end of the fourth resistor R4 is the output end Wo of the bias circuit B, similarly to the emitter terminal of the fifth transistor Tr5. The fourth resistor R4 configures a resistive voltage-dividing circuit together with the fifth resistor R5 connected in series with the fourth resistor R4.

The fifth resistor R5 has a predetermined fifth resistance value, and one end of the fifth resistor R5 is connected to the ground line Wg of the bias circuit B, that is, the emitter terminal of the third transistor Tr3 and one end of the capacitor C, and the other end thereof is connected to the base terminal of the fourth transistor Tr4 and the one end of the fourth resistor R4. The fifth resistor R5 configures the resistive voltage-dividing circuit together with the fourth resistor R4 connected in series with the fifth resistor R5.

The one end of the capacitor C is connected to the ground line Wg of the bias circuit B, that is, the ground terminal GND, the emitter terminal of the third transistor Tr3, and the one end of the fifth resistor R5, and the other end thereof is connected to the output end Wo of the bias circuit B, that is, the emitter terminal of the fifth transistor Tr5 and the other end of the fourth resistor R4. The capacitor C is provided in order to reduce an alternating current impedance at the output end Wo of the bias circuit B.

Such a bias circuit B is a constant voltage circuit including the third transistor Tr3, the fourth transistor Tr4, the fifth transistor Tr5, the second resistor R2, the third resistor R3, the fourth resistor R4, the fifth resistor R5, and the capacitor C. That is, the bias circuit B supplies the output voltage Vc having a constant voltage, as the base bias voltage, to the base terminal (control end) of the second transistor Tr2 in the main circuit M, from the output end of the bias circuit B, to cause the main circuit M to perform an amplification operation.

Next, an operation and performance of the high-frequency power amplifier A according to the first embodiment will be described in detail with reference to FIGS. 2A to 4.

In the high-frequency power amplifier A, the second resistance value in the second resistor R2 is set such that the third transistor Tr3 functioning as a diode is in the ON state (conduction state). The base-emitter voltage (base-collector voltage) $V_{BE1}$ of the third transistor Tr3 in the ON state (conduction state) is a breakdown voltage of a PN junction that physically configures the third transistor Tr3, and is a first constant voltage that is not affected by the power supply voltage, which is conducted to the power supply line Wd via the power supply terminal Vcc.

Further, the fourth transistor Tr4 is set to the ON state (conduction state) by the third resistor R3, the fifth transistor Tr5, the fourth resistor R4, and the fifth resistor R5. That is, the fifth transistor Tr5, the fourth resistor R4, and the fifth resistor R5 set the base voltage of the fourth transistor Tr4 such that the fourth transistor Tr4 is set to the ON state (conduction state). Further, the third resistor R3 sets an ON current (collector current) of the fourth transistor Tr4.

The base-emitter voltage $V_{BE2}$ of the fourth transistor Tr4 in the ON state (conduction state) is a breakdown voltage of a PN junction that physically configures the fourth transistor Tr4. That is, the base-emitter voltage of the fourth transistor Tr4 is a second constant voltage that is not affected by the power supply voltage, which is conducted to the power supply line Wd via the power supply terminal Vcc.

Further, the fourth transistor Tr4 is connected in series with the third transistor Tr3 that functions as a diode and whose collector voltage is set to the first reference voltage $V_{BE1}$. Therefore, the base voltage of the fourth transistor Tr4 is the reference constant voltage $(V_{BE1} + V_{BE2})$ obtained by adding the second constant voltage $V_{BE2}$ to the first constant voltage $V_{BE1}$.

Further, a base voltage of the fifth transistor Tr5 is a voltage obtained by dividing the power supply voltage by the third resistor R3 and a series circuit of the third transistor Tr3 and the fourth transistor Tr4, and the fifth transistor Tr5 is set to the ON state (conduction state). With the setting of the fourth transistor Tr4 to the ON state (conduction state) accordingly, a voltage difference between the base terminal of the fourth transistor Tr4 and the ground line Wg (ground potential) becomes the reference constant voltage $(V_{BE1} + V_{BE2})$.

In a case where the fourth resistance value is Ra and the fifth resistance value is Rb, a voltage difference between the emitter terminal of the fifth transistor Tr5 and the ground line Wg (ground potential), that is, the output voltage Vc of the bias circuit B is provided by the following equation (1) consisting of the fourth resistance value Ra, the fifth resistance value Rb, and the reference constant voltage $(V_{BE1} + V_{BE2})$.

$$ Vc = (1 + Ra/Rb) \cdot (V_{BE1} + V_{BE2}) \ (1) $$

That is, the output voltage Vc of the bias circuit B is decided only by the base-emitter voltage $V_{BE1}$ (first constant voltage) of the third transistor Tr3, the base-emitter voltage $V_{BE2}$ (second constant voltage) of the fourth transistor Tr4, the fourth resistance value Ra of the fourth resistor R4, and the fifth resistance value Rb of the fifth resistor R5. The output voltage Vc of the bias circuit B does not depend on the power supply voltage, which is conducted to the power supply line Wd via the power supply terminal Vcc.

FIG. 2A shows input/output characteristics of the high-frequency power amplifier A. FIG. 2A is an example of the input/output characteristics of the high-frequency power amplifier A obtained by analysis on the assumption that there are parasitic resistances of 0, 1, 2, and 5 $\Omega$ between the external direct-current voltage power supply and the power supply terminal Vcc. FIG. 2B represents a reference example in a case where the power supply voltage of the power supply terminal Vcc is subjected to resistive voltage-dividing to generate the base bias voltage of the second transistor Tr2.

In FIGS. 2A and 2B, a horizontal axis represents input power (dBm) to the high-frequency power amplifier, and a vertical axis represents output power (dBm) of the high-frequency power amplifier. The frequency of the input signal to the high-frequency power amplifier A is 28 GHz. As shown in FIGS. 2A and 2B, in a case where the parasitic resistance between the external direct-current voltage power supply and the power supply terminal Vcc is 0 $\Omega$, the input/output characteristics of the high-frequency power amplifier A substantially match the input/output characteristics of the reference example. However, the output power of the reference example becomes smaller than the output power of the high-frequency power amplifier A as the value of the parasitic resistance becomes larger.

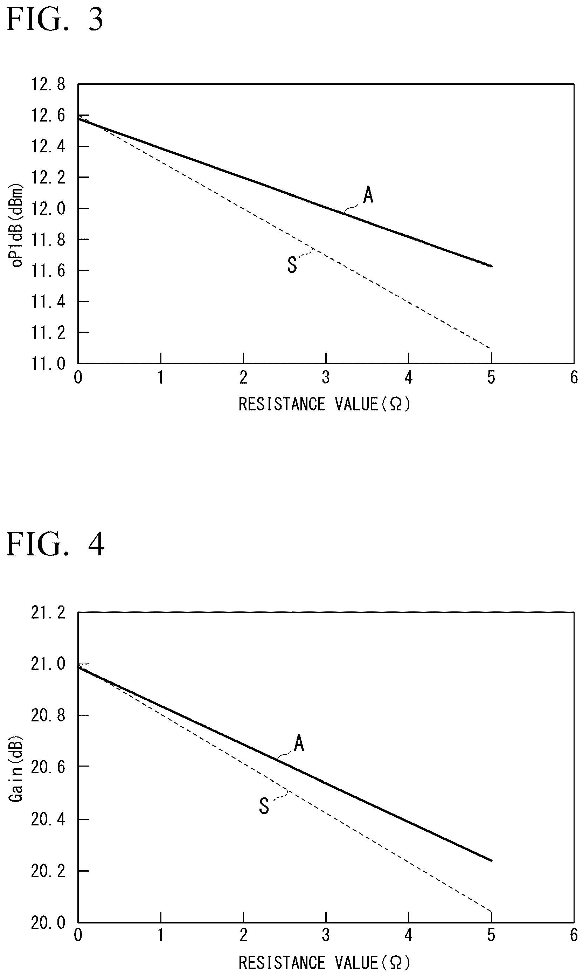

FIG. 3 shows oP1dB characteristics of the high-frequency power amplifier A. The oP1dB is a general performance index for evaluating gain linearity of a current amplifier, and is defined as output power in a case where a gain is reduced by 1 dB as compared with a case of a small signal. FIG. 3 shows an analysis result of oP1dB of the high-frequency power amplifier A obtained on the assumption that there are parasitic resistances of 0, 1, 2, and 5 $\Omega$ between the external direct-current voltage power supply and the power supply terminal Vcc. In FIG. 3, the characteristics of the high-frequency power amplifier A are indicated as "A", and the case where the power supply voltage of the power supply terminal Vcc is subjected to the resistive voltage-dividing to generate the base bias voltage of the second transistor Tr2 is added as a comparative example S.

In FIG. 3, a horizontal axis represents a value ($\Omega$) of the parasitic resistance, and a vertical axis represents oP1dB (dBm) of the high-frequency power amplifier A. As shown in FIG. 3, in a case where the parasitic resistance between the external direct-current voltage power supply and the power supply terminal Vcc is 0 $\Omega$, the oP1dB of the high-frequency power amplifier A substantially matches the oP1dB of the comparative example S. However, the oP1dB of the high-frequency power amplifier A is kept higher than the oP1dB of the comparative example S as the value of the parasitic resistance becomes larger.

Further, FIG. 4 shows small-signal gain characteristics of the high-frequency power amplifier A. FIG. 4 is an analysis result of a small-signal gain obtained on the assumption that there are parasitic resistances of 0, 1, 2, and 5 $\Omega$ between the external direct-current voltage power supply and the power supply terminal Vcc. In FIG. 4, a horizontal axis represents a value ($\Omega$) of the parasitic resistance, and a vertical axis represents a small-signal gain (dB). In FIG. 4, the characteristics of the high-frequency power amplifier A are indicated as "A", and the case where the power supply voltage of the power supply terminal Vcc is subjected to the resistive voltage-dividing to generate the base bias voltage of the second transistor Tr2 is added as a comparative example S.

As shown in FIG. 4, in a case where the parasitic resistance between the external direct-current voltage power supply and the power supply terminal Vcc is 0 $\Omega$, the small-signal gain of the high-frequency power amplifier A substantially matches the small-signal gain of the comparative example S. However, the small-signal gain of the high-frequency power amplifier A is kept higher than the small-signal gain of the comparative example S as the value of the parasitic resistance becomes larger.

In the high-frequency power amplifier A according to the first embodiment, the bias circuit B supplies the base bias voltage (output voltage Vc), which is not dependent on the power supply voltage in a case of being conducted to the power supply line Wd via the power supply terminal Vcc, to the second transistor Tr2 of the main circuit M. Therefore, according to the first embodiment, it is possible to provide the high-frequency power amplifier A capable of suppressing the reduction in the output power due to the voltage drop in the base bias voltage of the second transistor Tr2.

Further, in a case where the base terminal of the fifth transistor Tr5 is connected to a wiring line between the third resistor R3 and the collector terminal of the fourth transistor Tr4 and the fifth transistor Tr5 is set to an OFF state (non-conduction state), the fourth transistor Tr4 is set to the OFF state (non-conduction state). As a result, the base voltage of the fifth transistor Tr5 is increased, and the fifth transistor Tr5 returns to the ON state (conduction state).

That is, in the high-frequency power amplifier A according to the first embodiment, since the bias circuit B is spontaneously activated, there is no need to separately prepare a starter circuit that forcibly activates the bias circuit B. Therefore, according to the first embodiment, it is possible to simplify the circuit configuration of the high-frequency power amplifier A.

[Second Embodiment]

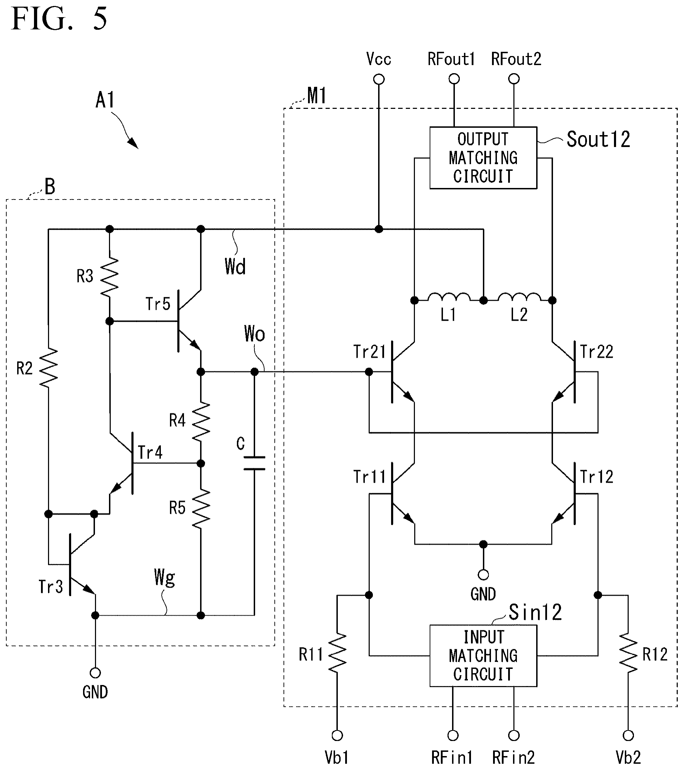

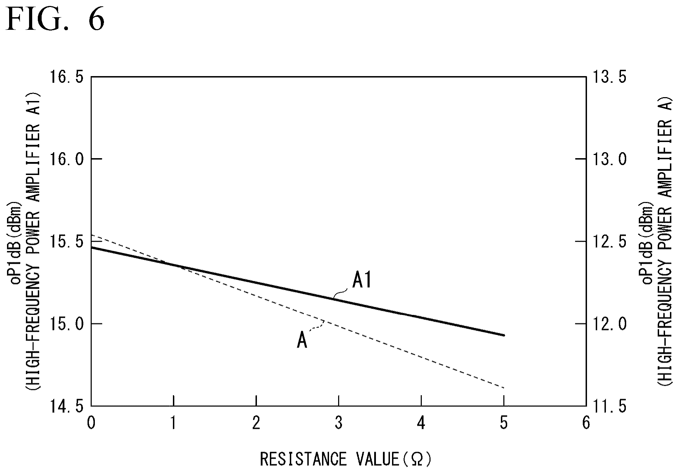

Next, a second embodiment of the present invention will be described with reference to FIGS. 5 and 6. As shown in FIG. 5, a high-frequency power amplifier A1 according to the second embodiment includes a main circuit M1 instead of the main circuit M of the high-frequency power amplifier A, includes a first high-frequency input terminal RFin1 and a second high-frequency input terminal RFin2 instead of the high-frequency input terminal RFin, includes a first bias terminal Vb1 and a second bias terminal Vb2 instead of the bias terminal Vb, and includes a first high-frequency output terminal RFout1 and a second high-frequency output terminal RFout2 instead of the high-frequency output terminal RFout.

The main circuit M1 includes the main circuit M according to the first embodiment as a pair. That is, as shown in the drawing, the main circuit M1 includes an input matching circuit Sin12, an eleventh transistor Tr11 (first initial-stage NPN type bipolar transistor), an eleventh resistor R11 (first resistor for amplification), a twenty-first transistor Tr21 (first next-stage NPN type bipolar transistor), a first inductor L1, a twelfth transistor Tr12 (second initial-stage NPN type bipolar transistor), a twelfth resistor R12 (second resistor for amplification), a twenty-second transistor Tr22 (second next-stage NPN type bipolar transistor), a second inductor L2, and an output matching circuit Sout12.

In the high-frequency power amplifier A1 according to the second embodiment, the eleventh transistor Tr11 and the twelfth transistor Tr12 correspond to the initial-stage transistors of the present invention. Further, in the high-frequency power amplifier A1 according to the second embodiment, the twenty-first transistor Tr21 and the twenty-second transistor Tr22 correspond to the next-stage transistors of the present invention.

The first high-frequency input terminal RFin1 is an input end of the high-frequency power amplifier A1 (main circuit M1) together with the second high-frequency input terminal RFin2, and is connected to one input end of a pair of input ends in the input matching circuit Sin12. A first high-frequency signal having a predetermined frequency is input to the high-frequency input terminal RFin1 from the outside. The first high-frequency signal is a first input signal in the high-frequency power amplifier A, and is input to one input end of the pair of input ends in the input matching circuit Sin12.

The second high-frequency input terminal RFin2 is an input end of the high-frequency power amplifier A1 (main circuit M1) together with the first high-frequency input terminal RFin1, and is connected to the other input end of the pair of input ends in the input matching circuit Sin12. A second high-frequency signal having a predetermined frequency is input to the second high-frequency input terminal RFin2 from the outside. The second high-frequency signal is a second input signal in the high-frequency power amplifier A, and is input to the other input end of the pair of input ends in the input matching circuit Sin12.

The input matching circuit Sin12 includes the pair of input ends and a pair of output ends.

In the input matching circuit Sin12, one input end of the pair of input ends is connected to the first high-frequency input terminal RFin1, and the other input end thereof is connected to the second high-frequency input terminal RFin2. Further, in the input matching circuit Sin12, one output end of the pair of output ends is connected to a base terminal of the eleventh transistor Tr11 and one end of the eleventh resistor R11, and the other output end thereof is connected to a base terminal of the twelfth transistor Tr12 and one end of the twelfth resistor R12.

The input matching circuit Sin12 is a passive circuit for impedance matching of a high-frequency signal (input signal), as in the input matching circuit Sin of the first embodiment. The input matching circuit Sin12 suppresses reflection of the first high-frequency signal (first input signal) and the second high-frequency signal (second input signal) to cause more power in the first high-frequency signal (first input signal) to be input to the eleventh transistor Tr11 and to cause more power in the second high-frequency signal (second input signal) to be input to the base terminal of the twelfth transistor Tr12.

The eleventh transistor Tr11 is an NPN type bipolar transistor as shown in the drawing, and the base terminal of the eleventh transistor Tr11 is connected to one output end of the input matching circuit Sin12 and the one end of the eleventh resistor R11. Further, an emitter terminal of the eleventh transistor Tr11 is connected to the ground terminal GND and an emitter terminal of the twelfth transistor Tr12, and a collector terminal thereof is connected to an emitter terminal of the twenty-first transistor Tr21.

The eleventh resistor R11 has a predetermined eleventh resistance value, and the one end of the eleventh resistor R11 is connected to one output end of the input matching circuit Sin12 and the base terminal of the eleventh transistor Tr11, and the other end thereof is connected to the first bias terminal Vb1. The eleventh resistor R11 is provided between the first bias terminal Vb1 and the base terminal of the eleventh transistor Tr11 in order to set a base voltage (bias voltage) of the eleventh transistor Tr11.

The first bias terminal Vb1 is a terminal to which a predetermined bias voltage is supplied from an external bias power supply. The first bias terminal Vb1 is connected to the other end of the eleventh resistor R11. The base voltage (bias voltage) of the eleventh transistor Tr11 is a parameter for setting the amplification degree of the eleventh transistor Tr11. The first bias terminal Vb1 is provided separately from the second bias terminal Vb2 in order to enable the setting of the amplification degree of the eleventh transistor Tr11 from the outside.

The twenty-first transistor Tr21 is an NPN type bipolar transistor, similar to the eleventh transistor Tr11, and a base terminal of the twenty-first transistor Tr21 is connected to the output end Wo of the bias circuit B and a base terminal of the twenty-second transistor Tr22. Further, the emitter terminal of the twenty-first transistor Tr21 is connected to the collector terminal of the eleventh transistor Tr11, and a collector terminal thereof is connected to one end of the first inductor L1 and one input end of the output matching circuit Sout12.

Such a twenty-first transistor Tr21 is connected in cascode with the eleventh transistor Tr11, and with an applied predetermined base bias voltage from the output end Wo of the bias circuit B, the twenty-first transistor Tr21 exhibits an amplification function together with the eleventh transistor Tr11. That is, a first amplified signal, which is an amplified first high-frequency signal (first input signal) in the main circuit M1, is generated at the collector terminal of the twenty-first transistor Tr21.

The first inductor L1 has a predetermined first inductance, and one end of the first inductor L1 is connected to the collector terminal of the twenty-first transistor Tr21 and one input end of the output matching circuit Sout12, and the other end thereof is connected to the power supply terminal Vcc, the power supply line Wd of the bias circuit B, and the other end of the second inductor L2. The first inductor L1 is a load of the twenty-first transistor Tr21.

The twelfth transistor Tr12 is an NPN type bipolar transistor as shown in the drawing, and the base terminal of the twelfth transistor Tr12 is connected to the other output end of the input matching circuit Sin12 and one end of the twelfth resistor R12. Further, the emitter terminal of the twelfth transistor Tr12 is connected to the ground terminal GND and the emitter terminal of the eleventh transistor Tr11, and a collector terminal thereof is connected to an emitter terminal of the twenty-second transistor Tr22.

The twelfth resistor R12 has a predetermined twelfth resistance value, and one end of the twelfth resistor R12 is connected to the other output end in the input matching circuit Sin12 and the base terminal of the twelfth transistor Tr12, and the other end thereof is connected to the bias terminal Vb. The twelfth resistor R12 is provided between the bias terminal Vb and the base terminal of the twelfth transistor Tr12 in order to set a base voltage (bias voltage) of the twelfth transistor Tr12.

The second bias terminal Vb2 is a terminal to which a predetermined bias voltage is supplied from an external bias power supply. The second bias terminal Vb2 is connected to the other end of the twelfth resistor R12. The base voltage (bias voltage) of the twelfth transistor Tr12 is a parameter for setting the amplification degree of the twelfth transistor Tr12.

Such a second bias terminal Vb2 is provided separately from the first bias terminal Vb1 in order to enable the setting of the amplification degree of the twelfth transistor Tr12 from the outside. The first bias terminal Vb1 and the second bias terminal Vb2 correspond to a pair of bias terminals in the present invention.

The twenty-second transistor Tr22 is an NPN type bipolar transistor, similar to the twelfth transistor Tr12, and the base terminal of the twenty-second transistor Tr22 is connected to the output end Wo of the bias circuit B and the base terminal of the twenty-first transistor 21. Further, the emitter terminal of the twenty-second transistor Tr22 is connected to the collector terminal of the twelfth transistor Tr12, and a collector terminal thereof is connected to one end of the second inductor L2 and the other input end of the output matching circuit Sout12.

Such a twenty-second transistor Tr22 is connected in cascode with the twelfth transistor Tr12, and with an applied predetermined base bias voltage from the output end Wo of the bias circuit B, the twenty-second transistor Tr22 exhibits the amplification function together with the twelfth transistor Tr12. That is, a second amplified signal, which is an amplified second high-frequency signal (second input signal) in the main circuit M1, is generated at the collector terminal of the twenty-second transistor Tr22.

The second inductor L2 has a predetermined second inductance, and one end of the second inductor L2 is connected to the collector terminal of the twenty-second transistor Tr22 and the other input end of the output matching circuit Sout12, and the other end thereof is connected to the power supply terminal Vcc, the power supply line Wd of the bias circuit B, and the other end of the first inductance L1. The second inductor L2 is a load of the twenty-second transistor Tr22.

The output matching circuit Sout12 includes a pair of input ends and a pair of output ends. In the output matching circuit Sout12, one input end of the pair of input ends is connected to the collector terminal of the twenty-first transistor Tr21 and one end of the first inductor L1, and the other input end thereof is connected to the collector terminal of the twenty-second transistor Tr22 and one end of the second inductor L2. Further, in the output matching circuit Sout12, one output end of the pair of output ends is connected to the first high-frequency output terminal RFout1, and the other output end thereof is connected to the second high-frequency output terminal RFout2.

The output matching circuit Sout12 is a passive circuit for impedance matching of the first amplified signal and the second amplified signal, which are the high-frequency signals. The output matching circuit Sout12 suppresses power reflection of the first amplified signal and the second amplified signal to cause more power in the first amplified signal to be input to a next-stage circuit connected externally to the first high-frequency output terminal RFout1 and to cause more power in the second amplified signal to be input to a next-stage circuit connected externally to the second high-frequency output terminal RFout2.

The first high-frequency output terminal RFout1 is an output end of the high-frequency power amplifier A1 (main circuit M1) together with the second high-frequency output terminal RFout2, and is connected to one output end of the pair of output ends in the output matching circuit Sout12. The first high-frequency output terminal RFout1 outputs a first output signal, which is an amplified first input signal (first high-frequency signal) by the high-frequency power amplifier A1 (main circuit M1), to the next-stage circuit.

The second high-frequency output terminal RFout2 is an output end of the high-frequency power amplifier A1 (main circuit M1) together with the first high-frequency output terminal RFout1, and is connected to the other output end of the pair of output ends in the output matching circuit Sout12. The second high-frequency output terminal RFout2 outputs a second output signal, which is an amplified second input signal (second high-frequency signal) by the high-frequency power amplifier A1 (main circuit M1), to the next-stage circuit.

The input matching circuit Sin12 has the same performance for the first high-frequency signal (first input signal) and the second high-frequency signal (second input signal), among the input matching circuit Sin12, the eleventh transistor Tr11, the eleventh resistor R11, the twenty-first transistor Tr21, the first inductor L1, the twelfth transistor Tr12, the twelfth resistor R12, the twenty-second transistor Tr22, the second inductor L2, and the output matching circuit Sout12, which are the components of the main circuit M1.

Further, the output matching circuit Sout12 has the same performance for the first amplified signal and the second amplified signal. Further, the eleventh transistor Tr11 and the twelfth transistor Tr12 are transistors forming a pair, and have the same characteristics. Further, the twenty-first transistor Tr21 and the twenty-second transistor Tr22 are transistors forming a pair, as in the eleventh transistor Tr11 and the twelfth transistor Tr12, and have the same characteristics.

Further, the eleventh resistance value in the eleventh resistor R11 and the twelfth resistance value in the twelfth resistor R12 are set to the same value. Further, the first inductance in the first inductor L1 and the second inductance in the second inductor L2 are set to the same value. Further, a phase of the first high-frequency signal (first input signal) input to the first high-frequency input terminal RFin 1 from the outside is inverted with respect to a phase of the second high-frequency signal (second input signal) input to the second high-frequency input terminal RFin 2 from the outside.

That is, the main circuit M1 is a differential amplification circuit that includes the initial-stage transistor (twelfth transistor Tr12) and the next-stage transistor (twenty-second transistor Tr22), as a pair, that are connected in cascode, as in the initial-stage transistor (eleventh transistor Tr11) and the next-stage transistor (twenty-first transistor Tr21) that are connected in cascode, and that performs differential amplification on the pair of input signals (first high-frequency signal and second high-frequency signal) having a relationship in which the phases are inverted to output the pair of output signals (first output signal and second output signal).

Further, for the eleventh transistor Tr11 and the twelfth transistor Tr12 (initial-stage transistors) and the twenty-first transistor Tr21 and the twenty-second transistor Tr22 (next-stage transistors) in the main circuit M1, emitter lengths of the twenty-first transistor Tr21 and the twenty-second transistor Tr22 (next-stage transistors) are set to be equal to emitter lengths of the eleventh transistor Tr11 and the twelfth transistor Tr12 (initial-stage transistors), or set to be larger than the emitter lengths thereof.

With the setting of the emitter lengths of the twenty-first transistor Tr21 and the twenty-second transistor Tr22 (next-stage transistors) to be larger than the emitter lengths of the eleventh transistor Tr11 and the twelfth transistor Tr12 (initial-stage transistors), it is possible to reduce a phase distortion of the main circuit M1.

The bias circuit B in the second embodiment is the same as the bias circuit B in the first embodiment, but in the main circuit M1 (differential amplification circuit), the same base bias voltage is supplied to the twenty-first transistor Tr21 and the twenty-second transistor Tr22, which form a pair and are each connected in cascode with the eleventh transistor Tr11 and the twelfth transistor Tr12 forming a pair.

FIG. 6 shows oP1dB characteristics of the high-frequency power amplifier A1. FIG. 6 shows the oP1dB characteristics of the high-frequency power amplifier A1 obtained by analysis of the oP1dB on the assumption that there are parasitic resistances of 0, 1, 2, and 5 $\Omega$ between the external direct-current voltage power supply and the power supply terminal Vcc, and shows the oP1dB characteristics of the high-frequency power amplifier A according to the first embodiment as a comparative example. In FIG. 6, a horizontal axis represents a value ($\Omega$) of the parasitic resistance, a left vertical axis represents oP1dB (dBm) of the high-frequency power amplifier A1, and a right vertical axis represents oP1dB (dBm) of the high-frequency power amplifier A.

As shown in FIG. 6, in a case where the parasitic resistance between the external direct-current voltage power supply and the power supply terminal Vcc is 0 $\Omega$, a value of oP1dB of the high-frequency power amplifier A1 is about 3 dB larger than a value of oP1dB of the high-frequency power amplifier A, and a reduction width of the value of oP1dB is smaller than that of the high-frequency power amplifier A as the value of the parasitic resistance becomes larger. That is, the high-frequency power amplifier A1 according to the second embodiment can suppress a reduction in the output power as compared with the high-frequency power amplifier A according to the first embodiment.

In such a high-frequency power amplifier A1 according to the second embodiment, the bias circuit B supplies the base bias voltage (output voltage Vc), which is not dependent on the power supply voltage in a case of being conducted to the power supply line Wd via the power supply terminal Vcc, to the twenty-first transistor Tr21 and the twenty-second transistor Tr22 of the main circuit M1. Therefore, according to the second embodiment, it is possible to provide the high-frequency power amplifier A1 capable of further suppressing the reduction in the output power due to the voltage drop in the base bias voltage of the twenty-first transistor Tr21 and the twenty-second transistor Tr22.

The present invention is not limited to the above embodiments, and for example, the following modification examples are considered.

(1) In the first and second embodiments described above, the bias circuit B (constant voltage circuit) having the circuit configuration shown in FIGS. 1 and 5 is employed, but the present invention is not limited thereto. That is, the bias circuit (constant voltage circuit) in the present invention is sufficient as long as the constant voltage can be supplied to the next-stage transistor as the bias voltage without depending on the parasitic resistance between the external direct-current voltage power supply and the power supply terminal Vcc. The high-frequency power amplifier may include, for example, a circuit configuration other than the bias circuit B.

(2) The NPN type bipolar transistor is employed as the plurality of transistors, but the present invention is not limited thereto. A PNP type bipolar transistor may be employed, instead of the NPN type bipolar transistor. Further, an N type or P type field effect transistor (FET) may be employed for the first transistor Tr1, the second transistor Tr2, the eleventh transistor Tr11, the twelfth transistor Tr12, the twenty-first transistor Tr21, and the twenty-second transistor Tr22, which function as the amplification elements.

(3) In the first and second embodiments, the reference constant voltage is generated by the base-emitter voltages $V_{BE1}$ and $V_{BE2}$ of the plurality of bipolar transistors, that is, the two bipolar transistors (third transistor Tr3 and fourth transistor Tr4), but the present invention is not limited thereto. The number of bipolar transistors for generating the reference constant voltage, that is, the number of bipolar transistors connected in series may be a plurality of two or more, or may be one as necessary.

(4) In the second embodiment, the case has been described in which the load inductor pair consisting of the first inductor L1 and the second inductor L2 is employed, but the present invention is not limited to this. One inductor (transformer) having a center tap may be employed, instead of the load inductor pair.

(5) In the second embodiment, the wire connection is employed for connecting the twenty-first transistor Tr21 and the twenty-second transistor Tr22 with the output matching circuit Sout12, but the present invention is not limited thereto. In the present connection, electromagnetic coupling using the above load inductor pair may be employed, instead of the wire connection.

(6) In the second embodiment, the second bias terminal Vb2 is provided separately from the first bias terminal Vb1, but the present invention is not limited thereto. That is, the first bias terminal Vb1 and the second bias terminal Vb2 may be shared as a single bias terminal.

REFERENCE SIGNS LIST

A, A1 High-frequency power amplifier
B Bias circuit
M, M1 Main circuit
Tr1 First transistor (Initial-stage NPN type bipolar transistor)
Tr2 Second transistor (Next-stage NPN type bipolar transistor)
Tr3 Third transistor (First NPN type bipolar transistor for bias)
Tr4 Fourth transistor (Second NPN type bipolar transistor for bias)
Tr5 Fifth transistor (Third NPN type bipolar transistor for bias)
Tr11 Eleventh transistor (First initial-stage NPN type bipolar transistor)
Tr12 Twelfth transistor (Second initial-stage NPN type bipolar transistor)
Tr21 Twenty-first transistor (First next-stage NPN type bipolar transistor)
Tr22 Twenty-second transistor (Second next-stage NPN type bipolar transistor)
R1 First resistor (Resistor for amplification)
R2 Second resistor (First resistor for bias)
R3 Third resistor (Second resistor for bias)
R4 Fourth resistor (Third resistor for bias)
R5 Fifth resistor (Fourth resistor for bias)
R11 Eleventh resistor (First resistor for amplification)
R12 Twelfth resistor (Second resistor for amplification)
C Capacitor
Sin, Sin12 Input matching circuit
Sout, Sout12 Output matching circuit
L Inductor
L1 First inductor
L2 Second inductor
RFin High-frequency input terminal
RFin1 First high-frequency input terminal
RFin2 Second high-frequency input terminal
RFout High-frequency output terminal
RFout1 First high-frequency output terminal
RFout2 Second high-frequency output terminal
Vb Bias terminal
Vb1 First bias terminal
Vb2 Second bias terminal
GND Ground terminal
Vcc Power supply terminal
Wd Power supply line
Wg Ground line
Wo Output end

**Claims**

1.  A power amplifier comprising:

    a main circuit that includes an initial-stage transistor and a next-stage transistor, which are connected in cascode, and is configured to amplify an input signal to output a high-frequency amplified signal; and
    a bias circuit that is configured to apply a bias voltage to the next-stage transistor,
    wherein the bias circuit is a constant voltage circuit that generates the bias voltage having a constant voltage based on a power supply supplied, from an outside, to a power supply terminal.

2.  The power amplifier according to Claim 1, wherein the bias circuit is configured to generate a reference constant voltage by a base-emitter voltage of one bipolar transistor or a base-emitter voltage of a plurality of bipolar transistors connected in series.

3.  The power amplifier according to Claim 2, wherein the number of the bipolar transistors is two.

4.  The power amplifier according to any one of Claims 1 to 3,
    wherein the main circuit is a differential amplification circuit that includes a pair of the initial-stage transistors and a pair of the next-stage transistors and that is configured to amplify a pair of input signals to output a pair of amplified signals.

5.  The power amplifier according to Claim 4, further comprising:
a pair of bias terminals that are configured to individually set amplification degrees of the initial-stage transistors.

6. The power amplifier according to any one of Claims 1 to 5,

wherein the bias circuit includes
a first NPN type bipolar transistor for bias having

an emitter terminal that is connected to a ground line, and a base terminal and a collector terminal that are commonly connected,

a second NPN type bipolar transistor for bias having

an emitter terminal that is connected to the base terminal and the collector terminal of the first NPN type bipolar transistor for bias,

a third NPN type bipolar transistor for bias having
a base terminal that is connected to a collector terminal of the second NPN type bipolar transistor for bias,
a first resistor for bias having

one end that is connected to the base terminal and the collector
terminal of the first NPN type bipolar transistor for bias, and
the other end that is connected to a power supply line,

a second resistor for bias having

one end that is connected to the power supply line, and
the other end that is connected to the collector terminal of the second
NPN type bipolar transistor for bias and the base terminal of the third
NPN type bipolar transistor for bias,

a third resistor for bias having

one end that is connected to a base terminal of the second NPN type bipolar transistor for bias, and
the other end that is connected to an emitter terminal of the third NPN type bipolar transistor for bias,

a fourth resistor for bias having

one end that is connected to the ground line, and
the other end that is connected to the base terminal of the second NPN
type bipolar transistor for bias and the one end of the third resistor for bias, and

a capacitor having

one end that is connected to the ground line, and
the other end that is connected to the emitter terminal of the third
NPN type bipolar transistor for bias and the other end of the third resistor for bias, and

the bias circuit outputs the bias voltage from the emitter terminal of the third NPN type bipolar transistor for bias.

7. The power amplifier according to any one of Claims 1 to 3 and 6,

wherein the main circuit includes
an input matching circuit having
an input end that is connected to a high-frequency input terminal,
an initial-stage NPN type bipolar transistor having

a base terminal that is connected to an output end of the input matching circuit, and
an emitter terminal that is connected to a ground terminal,

a resistor for amplification having

one end that is connected to the output end of the input matching
circuit and a base terminal of the initial-stage transistor, and the other end that is connected to a bias terminal,

a next-stage NPN type bipolar transistor having

an emitter terminal that is connected to a collector terminal of the initial-stage NPN type bipolar transistor, and
a base terminal that receives the bias voltage,

an inductor having

one end that is connected to a collector terminal of the next-stage NPN type bipolar transistor, and
the other end that is connected to a power supply terminal, and

an output matching circuit having

> an input end that is connected to the collector terminal of the next-stage NPN type bipolar transistor and one end of the inductor, and
> an output end that is connected to a high-frequency output terminal.

8. The power amplifier according to any one of Claims 1 to 6,

> wherein the main circuit includes an input matching circuit having

> > one input end that is connected to a first high-frequency input terminal, and
> > the other input end that is connected to a second high-frequency input terminal,

> a first initial-stage NPN type bipolar transistor having

> > a base terminal that is connected to the one output end of the input matching circuit, and
> > an emitter terminal that is connected to a ground terminal,

> a second initial-stage NPN type bipolar transistor having

> > a base terminal that is connected to the other output end of the input matching circuit, and
> > an emitter terminal that is connected to the ground terminal,

> a first resistor for amplification having

> > one end that is connected to the one output end of the input matching circuit and the base terminal of the first initial-stage NPN type bipolar transistor, and
> > the other end that is connected to a first bias terminal,

> a second resistor for amplification having

> > one end that is connected to the other output end of the input matching circuit and the base terminal of the second initial-stage NPN type bipolar transistor, and
> > the other end that is connected to a second bias terminal,

> a first next-stage NPN type bipolar transistor having

> > an emitter terminal that is connected to a collector terminal of the first initial-stage NPN type bipolar transistor, and
> > a base terminal that receives the bias voltage,

> a second next-stage NPN type bipolar transistor having

> > an emitter terminal that is connected to a collector terminal of the second initial-stage NPN type bipolar transistor, and
> > a base terminal that receives the bias voltage,

> a first inductor having

> > one end that is connected to a collector terminal of the first next-stage NPN type bipolar transistor, and
> > the other end that is connected to a power supply terminal,

> a second inductor having

> > one end that is connected to a collector terminal of the second next-stage NPN type bipolar transistor, and
> > the other end that is connected to the power supply terminal, and

> an output matching circuit having

> > one input end that is connected to the collector terminal of the first next-stage NPN type bipolar transistor and the one end of the first inductor,
> > the other input end that is connected to the collector terminal of the second next-stage NPN type bipolar transistor and the one end of the second inductor,
> > one output end that is connected to a first high-frequency output terminal, and
> > the other output end that is connected to a second high-frequency output terminal.

9. The power amplifier according to any one of Claims 1 to 8,
wherein an emitter length of the next-stage transistor is set to be larger than an emitter length of the initial-stage transistor.

FIG. 1

FIG. 2A

FIG. 2B

## FIG. 3

## FIG. 4

FIG. 5

FIG. 6

## INTERNATIONAL SEARCH REPORT

International application No.

**PCT/JP2024/004655**

### A. CLASSIFICATION OF SUBJECT MATTER

*H03F 1/30*(2006.01)i; *H03F 1/22*(2006.01)i; *H03F 3/21*(2006.01)i; *H03F 3/45*(2006.01)i
FI: H03F1/30 220; H03F1/22; H03F3/21; H03F3/45

According to International Patent Classification (IPC) or to both national classification and IPC

### B. FIELDS SEARCHED

Minimum documentation searched (classification system followed by classification symbols)

H03F1/30; H03F1/22; H03F3/21; H03F3/45

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2015-115835 A (MURATA MANUFACTURING CO., LTD.) 22 June 2015 (2015-06-22) paragraphs [0048]-[0056], fig. 7-8 | 1, 4-5, 7, 9 |
| A | | 2-3, 6, 8 |
| X | JP 4-52643 B2 (HITACHI, LTD.) 24 August 1992 (1992-08-24) column 5, line 2 to column 6, line 21, fig. 5 | 1, 4-5, 9 |
| A | | 2-3, 6-8 |
| X | Microfilm of the specification and drawings annexed to the request of Japanese Utility Model Application No. 71664/1971 (Laid-open No. 28366/1973) (JAPAN BROADCASTING CORPORATION) 06 April 1973 (1973-04-06), page 6, line 13 to page 8, line 3, fig. 3 | 1, 4-5, 9 |
| A | | 2-3, 6-8 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 April 2024** | **23 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/004655**

| Patent document cited in search report | | | Publication date (day/month/year) | Patent family member(s) | | | Publication date (day/month/year) |
|---|---|---|---|---|---|---|---|
| JP | 2015-115835 | A | 22 June 2015 | US<br>paragraphs [0060]-[0068], fig. 7-8<br>CN | 2015/0171796<br><br>104716908 | A1<br><br>A | |
| JP | 4-52643 | B2 | 24 August 1992 | US<br>column 2, lines 3-64, fig. 3 | 4587495 | A | |
| JP | 48-28366 | U1 | 06 April 1973 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023019122 A

- JP 2012147307 A